# EUROPEAN PATENT SPECIFICATION

(11) **EP 1 074 343 B1**
(45) Date of publication and mention of the grant of the patent: **06.07.2005**
(21) Application number: 00107147.1
(22) Date of filing: 10.04.2000
(51) Int. Cl.: B24B 37/04, H01L 21/304

(54) **Polishing method and apparatus**
Verfahren und Vorrichtung zum Polieren
Procédé et dispositif pour le polissage

(30) Priority: 04.08.1999 JP 10112599
(43) Date of publication of application: 07.02.2001
(73) Proprietor: EBARA CORPORATION, Ohta-ku, Tokyo (JP)
(72) Inventor: Kimura, Norio, Fujisawa-shi, Kanagawa-ken (JP); Shirakashi, Mitsuhiko, Fujisawa-shi, Kanagawa-ken (JP); Tokushige, Katsuhiko, Sagamihara-shi,Kanagawa-ken (JP); Asami, Masao, Kawasaki-shi, Kanagawa-ken (JP); Miyashita, Naoto, Yokohama-shi, Kanagawa-ken (JP); Kodera, Masako, Yokohama-shi, Kanagawa-ken (JP); Matsui, Yoshitaka, Yokohama-shi, Kanagawa-ken (JP); Nadahara, Soichi, Yokohama-shi, Kanagawa-ken (JP); Tomita, Hiroshi, Yokohama-shi, Kanagawa-ken (JP)
(74) Representative: Wagner, Karl H., Dipl.-Ing.

(56) References cited:
- EP-A- 0 806 265
- EP-A- 0 913 442
- GB-A- 2 324 750
- US-A- 5 931 722

## Description

### BACKGROUND OF THE INVENTION

### Field of the Invention:

The present invention relates to a polishing method and apparatus, as per the preamble of claims 1 and 13. An example of such an apparatus and method is disclosed by US 5 931 722 A.

### Description of the Related Art:

Conventionally, in order to form a wiring circuit on a semiconductor substrate, a conductive film is deposited over a surface of a substrate by a sputtering process or the like, and then unnecessary portions are removed from the conductive film by a chemical dry etching process using a photoresist for a mask pattern.

Generally, aluminum or aluminum alloy has been used as a material for forming a wiring circuit. However, the higher integration of integrated circuits on the semiconductor substrate in recent years requires the narrower wiring to thus increase the current density, resulting in generating thermal stress in the wiring and increasing the temperature of the wiring. This unfavorable condition becomes more significant, as wiring material such as aluminum is thinner due to stress-migration or electromigration, finally to cause a breaking of wire or a short circuit.

Hence, in order to prevent the wiring from generating excess heat while current flows, a material such as copper having a higher electrical conductivity is required to be used for a wiring circuit. However, since copper or copper alloy is not suited for the dry etching process, it is difficult to adopt the above-mentioned method in which the wiring pattern is formed after depositing the conductive film over the whole surface of the substrate. Therefore, one of possible processes is that grooves for a wiring circuit having a predetermined pattern are formed, and then the grooves are filled with copper or copper alloy. This process eliminates the etching process of removing unnecessary portions of the film, and needs only a polishing process of removing unevenness or irregularities of the surface. Further, this process offers advantages that portions called wiring holes connecting between an upper layer and a lower layer in a multilayer circuit can be formed at the same time.

However, as the width of wiring is narrower, such wiring grooves or wiring holes have a considerably higher aspect ratio (the ratio of depth to diameter or width), and hence it is difficult to fill the grooves or the holes with metal uniformly by the sputtering process. Further, although a chemical vapor deposition (CVD) process is used to deposit various materials, it is difficult to prepare an appropriate gas material for copper or copper alloy, and if an organic material is used for depositing copper or copper alloy, carbon (C) is mixed into a deposited film to increase migration of the film.

Therefore, there has been proposed a method in which a substrate is dipped in a plating solution to plate the substrate with copper by an electrolytic plating or an electroless plating and then unnecessary portion of a copper layer is removed from the substrate by a chemical mechanical polishing (CMP) process. This formation of film or layer by the plating allows wiring grooves having a high aspect ratio to be uniformly filled with a metal having a high electrical conductivity. In the CMP process, a semiconductor wafer held by the top ring is pressed against a polishing cloth attached to a turntable, while supplying a polishing liquid containing abrasive particles, and thus the copper layer on the semiconductor wafer is polished.

Immediately after the copper layer is polished in the CMP process, a polished surface of the copper layer on the semiconductor wafer has a high activity so that the polished surface is liable to be oxidized. If the polished surface on the semiconductor wafer is left as it is, then an oxide film is formed by natural oxidation on the polished surface of the semiconductor wafer. However, such oxide film tends to be formed irregularly or nonuniformly because any control is not made for formation of the oxide film, and hence the formed oxide film is of poor quality. If the oxide film is left as it is, then oxidation of the polished surface of the semiconductor wafer is further being developed. Particularly, in the case where copper is used as a material for forming a wiring circuit of semiconductor device, electric characteristics are changed to produce products inferior in quality.

Further, during polishing, a polishing liquid or by-product generated by polishing reaches the back surface opposite to the polished surface of the semiconductor wafer and is attached thereto, and may possibly contaminate atmosphere in a clean room.

Further, US-A-5,931,722 shows a chemical mechanical polishing apparatus which delivers pressurized slurry to polishing pads, for achieving good polishing results.

The apparatus also has a washing solution nozzle directed onto the polished surface for washing the same.

In order to solve the above mentioned problems, the present invention provides a method as per claim 1 and an apparatus as per claim 13.

In a preferred embodiment, the electrolyzed water supply device supplies electrolyzed water to the front and back surfaces of the substrate. The polishing apparatus further comprises an ultrasonic transducer for applying ultrasonic vibrations to the electrolyzed water before supplying the electrolyzed water to the substrate.

The polishing apparatus further comprises a supply device for supplying diluted hydrofluoric acid to the substrate.

Additionally the electrolyzed water supply device is provided at a plurality of locations from the polishing section to the cleaning section in the polishing apparatus.

After the copper layer of the substrate having a semiconductor device is polished, the front surface (surface having the copper layer) and the back surface are cleaned by electrolyzed water such as anode electrolyzed water.

The electrolyzed water is obtained by electrolyzing pure water, or pure water to which electrolyte is added. The electrolyzed water is classified into anode electrolyzed water having a large oxidizing capability and cathode electrolyzed water having a large reducing capability. The anode electrolyzed water is preferably used for oxidizing the surface of the copper layer (film) on the substrate after polishing.

The above and other objects, features, and advantages of the present invention will be apparent from the following description when taken in conjunction with the accompanying drawings which illustrates preferred embodiments of the present invention by way of example.

### BRIEF DESCRIPTION OF THE DRAWINGS

FIG. 1 is a schematic plan view of a polishing apparatus according to an embodiment of the present invention;
FIG. 2 is a perspective view of the polishing apparatus shown in FIG. 1;
FIG. 3 is a vertical cross-sectional view of a polishing unit in the polishing apparatus according to the embodiment of the present invention; and
FIG. 4 is a schematic side view of a cleaning unit in the polishing apparatus according to the embodiment of the present invention.

### DETAILED DESCRIPTION OF THE PREFERRED EMBODIMENTS

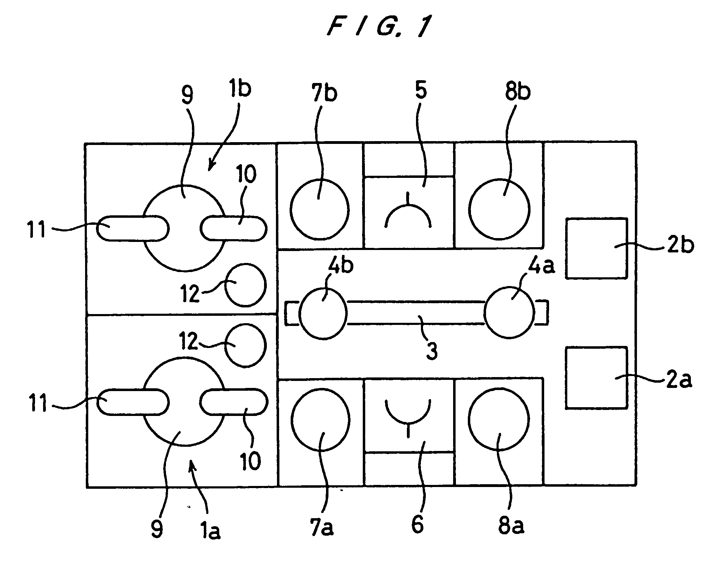

A polishing apparatus and method according to an embodiment of the present invention will be described below with reference to FIGS. 1 through 4.

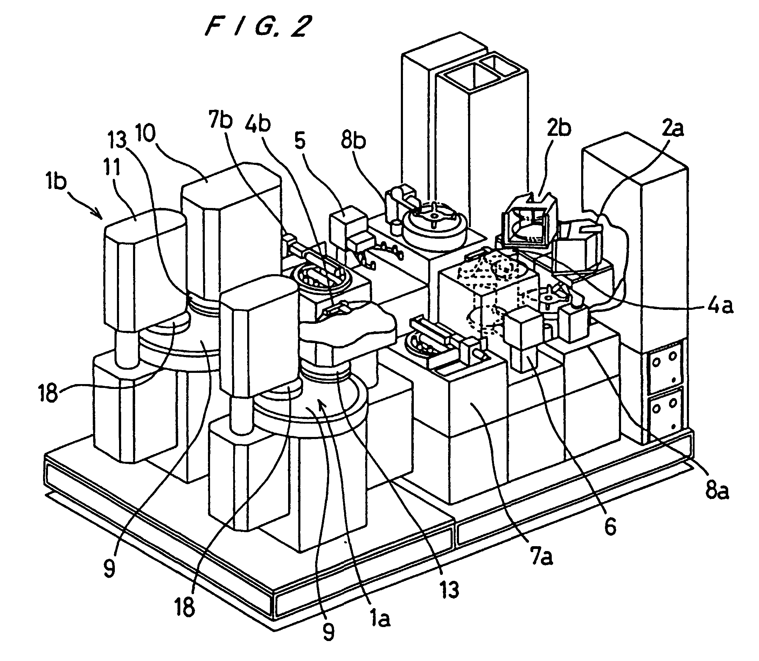

As shown in FIGS. 1 and 2, a polishing apparatus comprises a pair of polishing units 1a, 1b positioned at one end of a rectangular floor space and spaced from each other in confronting relation to each other, and a pair of loading/unloading units positioned at the other end of the rectangular floor space and having respective wafer cassettes 2a, 2b spaced from the polishing units 1a, 1b in confronting relation thereto. Two transfer robots 4a, 4b are movably mounted on a rail 3 which extends between the polishing units 1a, 1b and the loading/unloading units, thereby providing a transfer line along the rail 3. The polishing apparatus also has a pair of reversing units 5, 6 disposed one on each side of the transfer line and two pairs of cleaning units 7a, 7b and 8a, 8b disposed one pair on each side of the transfer line. The reversing unit 5 is positioned between the cleaning units 7b and 8b, and the reversing unit 6 is positioned between the cleaning units 7a and 8a. Each of the reversing units 5, 6 serves to reverse a semiconductor wafer, i.e. turn the semiconductor wafer over.

The polishing units 1a and 1b are of basically the same specifications, and are located symmetrically with respect to the transfer line. At least one of the polishing units 1a and 1b constitutes a polishing section. Each of the polishing units 1a, 1b comprises a turntable 9 with a polishing cloth attached to an upper surface thereof, a top ring head 10 for holding a semiconductor wafer under vacuum and pressing the semiconductor wafer against the polishing cloth on the upper surface of the turntable 9, and a dressing head 11 for dressing the polishing cloth.

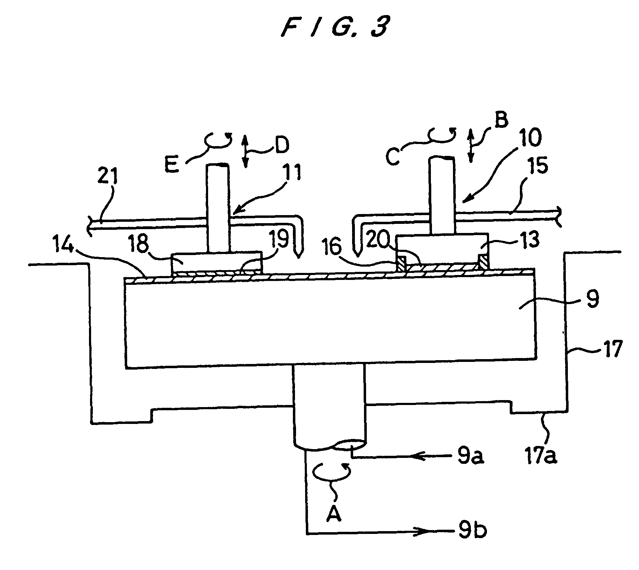

FIG. 3 shows a detailed structure of the polishing unit 1a or 1b.

As shown in FIG. 3, the top ring head 10 has a top ring 13 positioned above the turntable 9 for holding a semiconductor wafer 20 and pressing the semiconductor wafer 20 against the turntable 9. The top ring 13 is located in an off-center position with respect to the turntable 9. The turntable 9 is rotatable about its own axis as indicated by the arrow A by a motor (not shown) which is coupled through a shaft comprising the axis to the turntable 9. A polishing cloth 14 constituting a polishing surface is attached to an upper surface of the turntable 9.

When the copper layer formed on the semiconductor wafer is polished, in some cases, heat is generated depending on a slurry, i.e. a polishing liquid. By such heat of reaction, chemical polishing action is accelerated in the Cu polishing process to cause change of a polishing rate. In order to avoid this problem, in the present invention, a material having a good thermal conductivity such as ceramics is used for the turntable 9 to stabilize the polishing rate.

The ceramics preferably comprises alumina ceramics or silicon carbide (SiC), and such material having a coefficient of thermal conductivity of 0.294 W/(cm × °C) (0.07 cal/(cm×sec×°C)) or higher is desirable. The turntable 9 composed of ceramics is provided with a liquid inlet 9a for introducing a liquid into the turntable and a liquid outlet 9b for discharging the liquid from the turntable to adjust temperature of the turntable.

The top ring 13 is coupled to a motor (not shown) and also to a lifting/lowering cylinder (not shown). The top ring 13 is vertically movable and rotatable about its own axis as indicated by the arrows B, C by the motor and the lifting/lowering cylinder. The top ring 13 can therefore press the semiconductor wafer 20 against the polishing cloth 14 under a desired pressure. The semiconductor wafer 20 is attached to a lower surface of the top ring 13 under vacuum or the like. A guide ring 16 is mounted on the outer circumferential edge of the lower surface of the top ring 13 for preventing the semiconductor wafer 20 from being dislodged from the top ring 13.

A polishing liquid supply nozzle 15 is disposed above the turntable 9 for supplying a polishing liquid containing abrasive particles onto the polishing cloth 14 attached to the turntable 9. A frame 17 is disposed around the turntable 9 for collecting the polishing liquid and water which are discharged from the turntable 9. The frame 17 has a gutter 17a formed at a lower portion thereof for draining the polishing liquid and water that has been discharged from the turntable 9.

The dressing head 11 has a dressing member 18 for dressing the polishing cloth 14. The dressing member 18 is positioned above the turntable 9 in diametrically opposite relation to the top ring 13. The polishing cloth 14 is supplied with a dressing liquid such as water from a dressing liquid supply nozzle 21 extending over the turntable 9. The dressing member 18 is coupled to a motor (not shown) and also to a lifting/lowering cylinder (not shown). The dressing member 18 is vertically movable and rotatable about its own axis as indicated by the arrows D, E by the motor and the lifting/lowering cylinder.

The dressing member 18 is of a disk shape having substantially the same diameter as the top ring 13 and has a lower surface to which a dressing tool 19 is attached. The polishing liquid supply nozzle 15 and the dressing liquid supply nozzle 21 extend to respective given positions near a rotation center of the turntable 9, and supply the polishing liquid, and the dressing liquid such as pure water, respectively.

The polishing unit 1a or 1b operates as follows:

The semiconductor wafer 20 is held on the lower surface of the top ring 13, and pressed against the polishing cloth 14 on the upper surface of the turntable 9. The turntable 9 and the top ring 13 are rotated relatively to each other for thereby bringing the lower surface of the semiconductor wafer 20 in sliding contact with the polishing cloth 14. At this time, the polishing liquid is supplied from the polishing liquid nozzle 15 to the polishing cloth 14. The lower surface of the semiconductor wafer 20 is now polished by a combination of a mechanical polishing action of abrasive particles in the polishing liquid and a chemical polishing action of an alkaline solution in the polishing liquid. The polishing liquid which has been applied to polish the semiconductor wafer 20 is scattered outwardly off the turntable 9 into the frame 17 under centrifugal forces caused by the rotation of the turntable 9, and collected by the gutter 17a in the lower portion of the frame 17. The polishing process comes to an end when the semiconductor wafer 20 is polished by a predetermined thickness of a surface layer thereof. When the polishing process is finished, the polishing properties of the polishing cloth 14 is changed and the polishing performance of the polishing cloth 14 deteriorates. Therefore, the polishing cloth 14 is dressed to restore its polishing properties by the dressing tool 19.

As shown in FIG. 1, each of the polishing units 1a, 1b also has a pusher 12 positioned near the transfer line 3 for transferring a semiconductor wafer 20 to and receiving a semiconductor wafer 20 from the top ring 13. The top ring 13 is swingable in a horizontal plane, and the pusher 12 is vertically movable.

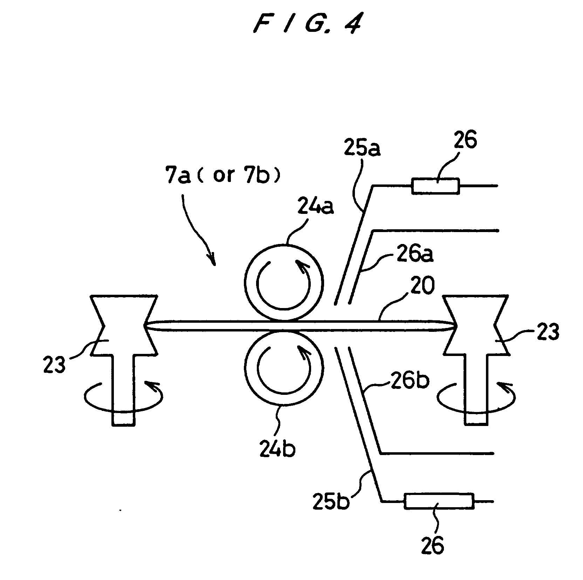

FIG. 4 is a schematic side view showing the structure of the cleaning units 7a, 7b. As shown in FIG. 4, each of the cleaning units 7a and 7b comprises a plurality of rollers 23 for holding the peripheral edge of the semiconductor wafer 20 and rotating the semiconductor wafer 20 in a horizontal plane, PVA (polyvinyl alcohol) sponge cleaning members 24a, 24b having a cylindrical shape for contacting and scrubbing the front and back surfaces of the semiconductor wafer 20, electrolyzed water supply nozzles 25a, 25b disposed above and below the semiconductor wafer 20, and DHF supply nozzles 26a, 26b disposed above and below the semiconductor wafer 20. An ultrasonic transducer 26 is provided in each of the lines of the electrolyzed water supply nozzles 25a, 25b. The electrolyzed water supply nozzles 25a, 25b supply anode electrolyzed water to the semiconductor wafer, and the DHF supply nozzles 26a, 26b supply DHF (diluted hydrofluoric acid) to the semiconductor wafer. At least one of the electrolyzed water supply nozzles 25a, 25b constitutes an electrolyzed water supply device, and at least one of the DHF supply nozzles 26a, 26b constitutes a supply device for supplying diluted hydrofluoric acid. The ultrasonic transducer 26 imparts ultrasonic vibrations to the anode electrolyzed water to produce megasonic anode electrolyzed water. It is desirable to produce electrolyzed water at a place as close as possible to the ionic wafer supply nozzles 25a, 25b for thereby lengthening life of the electrolyzed water, i.e., preventing change of concentration of the electrolyzed water. Further, it is desirable to install a measuring device and/or a controller for monitoring and/or controlling characteristic values such as pH or ion concentration in an electrolyzed water generator.

Each of the cleaning units 8a, 8b comprises a cleaning machine in which the semiconductor wafer 20 is cleaned by supplying pure water, or anode electrolyzed water and/or megasonic electrolyzed water while holding the peripheral edge of the semiconductor wafer 20 and rotating the semiconductor wafer 20. The cleaning units 8a, 8b also serve as a drier for drying the semiconductor wafer 20 in a spin-drying process. Thus, the semiconductor wafer 20 which has been polished is primarily cleaned in the cleaning units 7a, 7b, and the semiconductor wafer 20 which has been primarily cleaned is secondarily cleaned in the cleaning units 8a, 8b. The purpose of supplying electrolyzed water to the surface of the substrate in the respective cleaning units and the reversing unit is to form metal-oxide film on the surface of the substrate. Further, the purpose of supplying DHF (diluted hydrofluoric acid) to the surface of the substrate is to dissolve metal-oxide film on the surface of the substrate and remove it therefrom. By supplying electrolyzed water or DHF at desirable places in the polishing apparatus and/or a desirable timing according to its purpose, the substrate having a uniform and good oxide film in quality can be obtained. At least one of the cleaning units 7a, 7b, 8a and 8b constitutes a cleaning section.

Each of the transfer robots 4a, 4b has an articulated arm mounted on a carriage which is movable along the rail 3. The articulated arm is bendable in a horizontal plane. The articulated arm has, on each of upper and lower portions thereof, two grippers that can act as dry and wet fingers. The transfer robot 4a operates to cover a region ranging from the reversing units 5, 6 to the wafer cassettes 2a, 2b, and the transfer robot 4b operates to cover a region ranging from the reversing units 5, 6 to the polishing units 1a, 1b.

The reversing units 5, 6 are required in the illustrated embodiment because of the wafer cassettes 2a, 2b which store semiconductor wafers with their surfaces, which are to be polished or have been polished, facing upwardly. However, the reversing units 5, 6 may be dispensed with if semiconductor wafers are stored in the wafer cassettes 2a, 2b with their surfaces, which are to be polished or have been polished, facing downwardly, and alternatively if the transfer robots 4a, 4b have a mechanism for reversing semiconductor wafers. In the illustrated embodiment, one of the reversing units 5, 6 serves to reverse a dry semiconductor wafer, and the other of the reversing units 5, 6 serves to reverse a wet semiconductor wafer. Further, the reversing units 5 and 6 may have a nozzle or nozzles for supplying pure water or anode electrolyzed water to the semiconductor wafer 20, when required depending on the processing.

Next, operation of the polishing apparatus having the above structure will be described below.

The semiconductor wafers 20 to be polished are stored in the wafer cassettes 2a, 2b, and after all processing conditions are inputted in the polishing apparatus, the polishing apparatus starts an automatic operation.

The processing flow in the automatic operation is as follows:
a) The semiconductor wafers 20 to be polished are set in the wafer cassettes 2a, 2b, and the wafer cassettes 2a, 2b are placed on the loading/unloading unit.
b) The transfer robot 4a takes out the semiconductor wafer 20 from the wafer cassette 2a or 2b and conveys the semiconductor wafer 20 to the reversing unit 5. The reversing unit 5 reverses the semiconductor wafer 20 to cause a surface to be polished to face downwardly.
c) The transfer robot 4b receives the semiconductor wafer 20 from the reversing unit 5, and transfers the semiconductor wafer 20 to the pusher 12 in the polishing unit 1a.
d) In the polishing unit 1a, the top ring 13 holds the semiconductor wafer 20 under vacuum, and a primary polishing of the semiconductor wafer 20 is conducted. At this time, only the copper layer formed on the semiconductor wafer 20 is basically polished. It is conceivable that the primary polishing is conducted only for removing the copper layer and the barrier layer is used for a stopper depending on the kind of a slurry, i.e. a polishing liquid. In this case, it is necessary to detect the barrier layer exposed to the outside in situ, i.e. during polishing. Such detection may be conducted by measuring current of the motor rotating the turntable or eddy current of a eddy current sensor incorporated in the top ring, or by incorporating an accelerometer or a temperature sensor for detecting the temperature of the turntable.
e) After polishing of the semiconductor wafer 20 is completed, the semiconductor wafer 20 held by the top ring 13 in the polishing unit 1a is returned to the pusher 12. Then, the semiconductor 20 is received from the pusher 12 by the transfer robot 4b and transferred to the cleaning unit 7a.
f) In the cleaning unit 7a, the front and back surfaces of the semiconductor wafer 20 are cleaned in a scrubbing cleaning process by the PVA (polyvinyl alcohol) sponge cleaning member 24a, 24b. In the cleaning unit 7a, the scrubbing cleaning process is conducted using only pure water. The front and back surfaces of the semiconductor wafer 20 are simultaneously cleaned to remove the slurry, i.e. the polishing liquid attached to the semiconductor wafer 20 in the primary polishing. At this time, anode electrolyzed water or cathode electrolyzed water may be supplied to the semiconductor wafer 20 by the electrolyzed water supply nozzles 25a, 25b, depending on the kind of slurry. Further, chemicals such as surfactant, ammonia, or citric acid may be supplied to the semiconductor wafer 20 by a nozzle or nozzles (not shown).
g) After cleaning of the semiconductor wafer 20 is completed, the semiconductor wafer 20 is received from the cleaning unit 7a by the transfer robot 4b, and transferred to the pusher 12 in the polishing unit 1b.
h) The semiconductor wafer 20 is held by the top ring 13 in the polishing unit 1b under vacuum, and a secondary polishing of the semiconductor wafer 20 is carried out in the polishing unit 1b. In many cases, the barrier layer is polished in the secondary polishing. This polishing is conducted using the ceramic turntable to stabilize the chemical polishing action. In this case, the end point of polishing is detected by the devices described in the step d).
   In the processing flow of the present invention, the surface of the semiconductor wafer 20 is oxidized by the anode electrolyzed water in the cleaning unit which conducts the cleaning process subsequent to the polishing process. Depending on the kind of oxidant, in the secondary polishing process, oxidant comprising, for example, anode electrolyzed water may be supplied to oxidize forcibly the surface of the copper layer on the semiconductor wafer 20, after stopping supply of the slurry (polishing liquid). In this case, an electrolyzed water supply nozzle shown in FIG. 4 is provided in the polishing unit 1b which is the polishing section.
i) After the polishing process is completed, the semiconductor wafer 20 is transferred to the pusher 12 by the top ring 13 in the polishing unit 1b, and received by the transfer robot 4b from the pusher 12. While the semiconductor wafer 20 is standing by above the pusher 12 during transfer to the pusher 12, anode electrolyzed water may be supplied to the semiconductor wafer 20 above the pusher 12.
j) The semiconductor wafer is transferred to the cleaning unit 7b by the transfer robot 4b, and the front and back surfaces of the semiconductor wafer 20 are cleaned in a scrubbing process by the cleaning unit 7b. In this case, first, the slurry (polishing liquid) is removed from the front and back surfaces of the semiconductor wafer 20 by scrubbing the surfaces of the semiconductor wafer 20 with the PVA sponge members 24a, 24b. At this time, pure water may be supplied, but anode electrolyzed water may be supplied from the outside or inside of each of the PVA sponge members to shorten the cleaning time.
k) In either case in which pure water is supplied or is not supplied, next, anode electrolyzed water is supplied to the front and back surfaces of the semiconductor wafer 20 from the electrolyzed water supply nozzles 25a, 25b to oxide the surface of the copper layer on the semiconductor wafer 20. At this time, it is desirable to use magasonic anode electrolyzed water produced by imparting ultrasonic vibrations to anode electrolyzed water by the ultraosnic transducer 26 to form copper-oxide film having a good quality.
   It is desirable to conduct an oxidation treatment as soon as possible after polishing, and hence the polishing apparatus has such a structure that electrolyzed water may be supplied to the substrate within five minutes after polishing. In this polishing apparatus, anode electrolyzed water may be supplied to the both surfaces of the semiconductor wafer 20.
l) Thereafter, DHF (diluted hydrofluoric acid) is supplied to the semiconductor wafer 20 to remove the oxide film on the semiconductor wafer 20. By this process, Cu adhesion is equal to or lower than 1×10¹¹ atoms/cm² on the silicon surface of the semiconductor wafer 20.
   In the polishing apparatus of the present invention, the cleaning unit 7b has not only the electrolyzed water supply nozzles 25a, 25b but also the DHF supply nozzles 26a, 26b so that DHF may be supplied to the semiconductor wafer 20 immediately after electrolyzed water is supplied to the semiconductor wafer 20.
m) After removing the oxide film from the semiconductor wafer 20, the semiconductor wafer 20 is received by the transfer robot 4b from the cleaning unit 7b and transferred to the reversing unit 6. In the reversing unit 6, the semiconductor wafer 20 is reversed.
n) The semiconductor wafer 20 is received by the transfer robot 4a from the reversing unit 6, and transferred to the cleaning unit 8a or 8b.
o) Thereafter, the semiconductor wafer 20 is dried by a spin-drying process, and received by the transfer robot 4a from the cleaning unit 8a or 8b and then returned to the wafer cassette 2a or 2b.

In the above system, the copper layer on the substrate is polished in a two-stage polishing, i.e. a primary polishing and a secondary polishing. However, from a standpoint of processing efficiency, if a slurry (polishing liquid) by which the copper layer on the substrate may be polished on a single polishing surface on a turntable is developed, then the steps from d) to g) in the steps from a) to o) may be eliminated.

Therefore, the polishing apparatus can be operated by the polishing units 1a, 1b not only in the above-described serial processing and but also in a parallel processing.

In this case, the change of the processing may be performed not by replacing a software but by operating a changeover switch on the operation board.

A processing flow in the parallel processing is as follows:

One semiconductor wafer 20 is processed in the following route: the wafer cassette 2a or 2b → the reversing device 5 → the polishing unit 1a → the cleaning unit 7a → the reversing unit 6 → the cleaning unit 8a → the wafer cassette 2a or 2b.

The other semiconductor wafer 20 is processed in the following route: the wafer cassette 2a or 2b → the reversing unit 5 → the polishing unit 16 → the cleaning unit 7b → the reversing unit 6 → the cleaning unit 8b → the wafer cassette 2a or 2b.

One of the reversing units 5 and 6 handles a dry semiconductor wafer, and the other of the reversing units 5 and 6 handles a wet semiconductor wafer in the same way as in the serial processing. The cleaning units disposed on either side of the transfer line may be used in the parallel processing.

In the parallel processing, polishing conditions in the polishing units 1a, 1b may be the same, and cleaning conditions in the cleaning units 8a, 8b may be the same. In the cleaning units 8a, 8b, after the semiconductor wafer 20 is cleaned and spin-dried, it is returned to the wafer cassette 2a or 2b.

The polishing apparatus is housed in its entirety in a housing having an exhaust duct, and hence substrates to be processed are introduced into the polishing apparatus in a dry condition, and polished and cleaned substrates are removed from the polishing apparatus in a dry condition. Thus, the polishing apparatus may be of a dry-in and dry-out type for introducing therein substrates such as semiconductor wafers having a copper layer in a dry condition and removing therefrom polished and cleaned substrates having a copper wiring circuit in a dry condition.

As described above, according to the present invention, after the copper layer (or film) formed on the substrate is polished, the layer (or film) having a stable quality can be obtained. Further, the substrate which has been polished can be returned to the wafer cassette without being contaminated with copper.

Further, waste liquid generated from electrolyzed water is extremely clean, compared with the case in which other chemicals are used, and therefore any special treatment is not required and a load on a waste liquid treatment facility can be reduced.

Although certain preferred embodiments of the present invention have been shown and described in detail, it should be understood that various changes and modifications may be made therein within the scope of the appended claims.

## Claims

1. A polishing method comprising:
polishing a surface of a substrate by holding the substrate and pressing the substrate against a polishing surface of a turntable (9), the surface of the substrate having a semiconductor device thereon; **characterized by**
cleaning at leas a polished surface of the substrate while supplying electrolyzed water to the substrate such that a metal-oxide film is formed on the polished surface of the substrate by said supplying electrolyzed water.

2. A polishing method according to claim 1, wherein the electrolyzed water is supplied to the polished surface and a back surface opposite to the polished surface.

3. A polishing method according to claim 1 or 2, further comprising applying ultrasonic vibrations to the electrolyzed water before supplying the electrolyzed water to the substrate.

4. A polishing method according to any one of Claims 1 to 3, further comprising supplying diluted hydrofluoric acid to the substrate after said cleaning and said supplying electrolyzed water.

5. A polishing method according to any one of claims 1 to 4, further comprising:
polishing secondarily the polished surface of the substrate by holding the substrate and pressing the substrate against another polishing surface of another turntable (9),

6. A polishing method according to claim 5, wherein the electrolyzed water comprises anode electrolyzed water.

7. A polishing method according to claim 5, further comprising supplying electrolyzed water to the substrate which has been secondarily polished while the substrate is Standing by for a subsequent operation.

8. A polishing method according to claim 5, further comprising cleaning the substrate which has been secondarily polished in a scrubbing cleaning process.

9. A polishing method according to claim 5, further comprising cleaning the substrate which has been secondarily polished by supplying electrolyzed water.

10. A polishing method according to claim 9, wherein the electrolyzed water supplied to the substrate which has been secondarily polished comprises anode electrolyzed water.

11. A polishing method according to claim 9, further comprising applying ultrasonic vibrations to the electrolyzed water supplied to the substrate which has been secondarily polished before supplying the electrolyzed water to the substrate.

12. A polishing method according to claim 5, further comprising; cleaning the substrate which has been secondarily polished and then drying the cleaned substrate; and
transferring the cleaned and dried substrate to a cassette (12a, 12b) .

13. A polishing apparatus comprising:
a polishing section (1a, 1 b) for polishing a surface of a substrate by holding the substrate and pressing the substrate against a polishing surface, the surface of the substrate having a semiconductor device thereon; **characterized by**
a cleaning section (7a, 7b, 8a, 8b) for cleaning at least a polished surface of the substrate while supplying electrolyzed water to the substrate by an electrolyzed water supply device (25a, 25b) such that a metal-Oxide film is formed on the polished surface of the substrate by said supplying electrolyzed water.

14. A polishing apparatus according to claim 13, wherein said electrolyzed water supply device supplies said electrolyzed water to said polished surface and a back surface opposite to said polished surface of the substrate.

15. A polishing apparatus according to claim 13 or 14, further comprising an ultrasonic transducer (26) for applying ultrasonic vibrations to said electrolyzed water before supplying said electrolyzed water to the substrate.

16. A polishing apparatus according to any one of claims 13 to 15, further comprising a supply device (26a, 26b) for supplying diluted hydrofluoric acid to the substrate.

17. A polishing apparatus according to any one of claims 13 to 16, wherein the substrate has a copper layer thereon.

18. A polishing apparatus according to any one of claims 13 to 17, wherein said polishing section further comprises another polishing surface for conducting a secondary polishing of the polished surface of the substrate by holding the substrate and pressing the substrate against said another polishing surface.

## Patentansprüche

1. Polierverfahren, das Folgendes aufweist:
Polieren einer Oberfläche eines Substrats durch Halten des Substrats und Drücken des Substrats gegen eine Polieroberfläche auf einem Drehtisch (9), wobei die Oberfläche des Substrats eine Halbleitereinrichtung darauf besitzt, **gekennzeichnet durch** Reinigen wenigstens einer polierten Oberfläche des Substrats während elektrolysiertes Wasser an das Substrat geliefert wird, so dass ein Metalloxidfilm auf der polierten Oberfläche des Substrats **durch** Liefern des elektrolysierten Wassers gebildet wird.

2. Polierverfahren nach Anspruch 1, wobei das elektrolysierte Wasser an die polierte Oberfläche und eine Rückseite, die der polierten Oberfläche gegenüberliegt, geliefert wird.

3. Polierverfahren nach Anspruch 1 oder 2, das ferner das Anlegen von Ultraschallvibrationen an das elektrolysierte Wasser vor dem Liefern des elektrolysierten Wassers an das Substrat aufweist.

4. Polierverfahren nach einem der Ansprüche 1 bis 3, das ferner das Liefern von verdünnter Flusssäure an das Substrat aufweist, und zwar nach dem Reinigen und dem Liefern des elektrolysierten Wassers.

5. Polierverfahren nach einem der Ansprüche 1 bis 4, das ferner die folgenden Schritte aufweist: Sekundäres Polieren der polierten Oberfläche des Substrats durch Halten des Substrats und Drücken des Substrats gegen eine weitere Polieroberfläche eines weiteren Drehtischs (9).

6. Polierverfahren nach Anspruch 5, wobei das elektrolysierte Wasser anodenelektrolysiertes Wasser aufweist.

7. Polierverfahren nach Anspruch 5, das ferner das Liefern von elektrolysierten Wasser an das Substrat aufweist, das sekundär poliert wurde, während das Substrat für einen nachfolgenden Vorgang ruht.

8. Polierverfahren nach Anspruch 5, das ferner das reinigende Substrat aufweist, das sekundär poliert wurde, und zwar in einem Schrubreinigungsvorgang.

9. Verfahren nach Anspruch 5, das ferner das Reinigen des sekundär polierten Substrats aufweist durch Liefern von elektrolysiertem Wasser.

10. Polierverfahren nach Anspruch 9, wobei das elektrolysierte Wasser, das an das sekundär polierte Substrat geliefert wird anodenelektrolysiertes Wasser aufweist.

11. Polierverfahren nach Anspruch 9, das ferner das Anlegen von Ultraschallvibrationen an das elektrolysierte Wasser aufweist, das an das sekundär polierte Substrat geliefert wird, und zwar vor dem Liefern des elektrolysierten Wassers an das Substrat.

12. Verfahren nach Anspruch 5, das ferner Folgendes aufweist: Reinigen des sekundär polierten Substrats und anschließendes Trocknen des gereinigten Substrats; und
Übertragen des gereinigten und getrockneten Substrats zu einer Aufnahme bzw. Kassette (21 a, 21 b).

13. Poliervorrichtung, die Folgendes aufweist:
einen Polierabschnitt (1a, 1b) zum Polieren einer Oberfläche eines Substrats durch Halten des Substrats und durch Drücken des Substrats gegen eine Polieroberfläche, wobei die Oberfläche des Substrats eine Halbleitervorrichtung darauf besitzt, **gekennzeichnet durch**
einen Reinigungsabschnitt (7a, 7b, 8a, 8b) zum Reinigen wenigstens einer polierten Oberfläche des Substrats während elektrolysiertes Wasser an das Substrat geliefert wird, **durch** eine Versorgungseinrichtung (25a, 25b) für elektrolysiertes Wasser, so dass ein Metalloxidfilm an der polierten Oberfläche des Substrats ausgebildet wird, in dem elektrolysiertes Wasser geliefert wird.

14. Poliervorrichtung nach Anspruch 13, wobei die Versorgungsvorrichtung für elektrolysiertes Wasser das elektrolysierte Wasser an die polierte Oberfläche und einer Rückseite, die der polierten Oberfläche des Substrats gegenüberliegt, liefert.

15. Poliervorrichtung nach Anspruch 13 oder 14, die ferner einen Ultraschallwandler (26) aufweist, zum Anlegen von Ultraschallvibrationen an das elektrolysierte Wasser, bevor das elektrolysierte Wasser an das Substrat geliefert wird.

16. Poliervorrichtung nach einem der Ansprüche 13 bis 15, die ferner eine Versorgungsvorrichtung (26a, 26b) für das Liefern verdünnter Flusssäure an das Substrat aufweist.

17. Poliervorrichtung nach einem der Ansprüche 13 bis 16, wobei das Substrat eine Kupferschicht darauf besitzt.

18. Poliervorrichtung nach einem der Ansprüche 13 bis 17, wobei der Polierabschnitt ferner eine weitere Polieroberfläche aufweist zum Durchführen einer Sekundärpolitur der polierten Oberfläche des Substrats durch Halten des Substrats und Drücken des Substrats gegen die weitere Polieroberfläche.

## Revendications

1. Procédé de polissage comprenant :
le polissage d'une surface d'un substrat en maintenant le substrat et en appuyant le substrat contre une surface de polissage d'une table tournante (9), la surface du substrat possédant un dispositif à semi-conducteurs dessus ; **caractérisé par** le nettoyage d'au moins une surface polie du substrat tout en fournissant de l'eau électrolysée au substrat de telle sorte qu'un film d'oxyde métallique soit formé sur la surface polie du substrat par ladite eau électrolysée fournie.

2. Procédé de polissage selon la revendication 1, dans lequel l'eau électrolysée est fournie à la surface polie et à une surface arrière opposée à la surface polie.

3. Procédé de polissage selon la revendication 1 ou 2, comprenant en outre l'application de vibrations ultrasonores sur l'eau électrolysée avant de fournir l'eau électrolysée au substrat.

4. Procédé de polissage selon l'une quelconque des revendications 1 à 3, comprenant en outre la fourniture d'acide fluorhydrique dilué au substrat après ledit nettoyage et ladite fourniture d'eau électrolysée.

5. Procédé de polissage selon l'une quelconque des revendications 1 à 4, comprenant en outre : le polissage secondaire de la surface polie du substrat en maintenant le substrat et en pressant le substrat contre une autre surface de polissage d'une autre table tournante (9).

6. Procédé de polissage selon la revendication 5, dans lequel l'eau électrolysée comprend de l'eau électrolysée anodisée.

7. Procédé de polissage selon la revendication 5, comprenant en outre la fourniture d'eau électrolysée au substrat qui a été poli de manière secondaire pendant que le substrat est en attente d'une opération ultérieure.

8. Procédé de polissage selon la revendication 5, comprenant en outre le nettoyage du substrat qui a été poli de manière secondaire lors d'un processus de nettoyage par récurage.

9. Procédé de polissage selon la revendication 5, comprenant en outre le nettoyage du substrat qui a été poli de manière secondaire en fournissant de l'eau électrolysée.

10. Procédé de polissage selon la revendication 9, dans lequel l'eau électrolysée fournie au substrat qui a été poli de manière secondaire comprend de l'eau électrolysée anodisée.

11. Procédé de polissage selon la revendication 9, comprenant en outre l'application de vibrations ultrasonores à l'eau électrolysée fournie au substrat qui a été poli de manière secondaire avant de fournir l'eau électrolysée au substrat.

12. Procédé de polissage selon la revendication 5, comprenant en outre : le nettoyage du substrat qui a été poli de manière secondaire, puis le séchage du substrat nettoyé ; et
le transfert du substrat nettoyé et séché vers une cassette (12a, 12b).

13. Appareil de polissage comprenant :
une section de polissage (1a, 1b) destinée à polir une surface d'un substrat en maintenant le substrat et en appuyant le substrat contre une surface de polissage, la surface du substrat ayant un dispositif à semi-conducteurs dessus ; **caractérisé par** une section de nettoyage (7a, 7b, 8a, 8b) destinée à nettoyer au moins une surface polie du substrat tout en fournissant de l'eau électrolysée au substrat à l'aide d'un dispositif d'alimentation en eau électrolysée (25a, 25b) de telle sorte qu'un film d'oxyde métallique soit formé sur la surface polie du substrat par ladite eau électrolysée fournie.

14. Appareil de polissage selon la revendication 13, dans lequel ledit dispositif d'alimentation en eau électrolysée fournit ladite eau électrolysée à ladite surface polie et à une surface arrière opposée à ladite surface polie du substrat.

15. Appareil de polissage selon la revendication 13 ou 14, comprenant en outre un transducteur ultrasonore (26) destiné à appliquer des vibrations ultrasonores à ladite eau électrolysée avant de fournir ladite eau électrolysée au substrat.

16. Appareil de polissage selon l'une quelconque des revendications 13 à 15, comprenant en outre un dispositif d'alimentation (26a, 26b) destiné à fournir de l'acide fluorhydrique dilué au substrat.

17. Appareil de polissage selon l'une quelconque des revendications 13 à 16, dans lequel le substrat possède une couche de cuivre dessus.

18. Appareil de polissage selon l'une quelconque des revendications 13 à 17, dans lequel ladite section de polissage comprend en outre une autre surface de polissage destinée à effectuer un polissage secondaire de la surface polie du substrat en maintenant le substrat et en pressant le substrat contre ladite autre surface de polissage.
